# EUROPEAN PATENT APPLICATION

(11) **EP 1 933 375 A2**
(43) Date of publication of application: **18.06.2008**
(21) Application number: 07150004.5
(22) Date of filing: 13.12.2007
(51) Int. Cl.: H01L 21/306, H01L 21/308

(54) **Methods for Recess Etching**

(30) Priority: 13.12.2006 US 869832 P; 12.12.2007 US 954981
(71) Applicant: Applied Materials, Inc., Santa Clara, CA 95054 (US)
(72) Inventor: Shen, Meihua, Fremont, CA 94539 (US); Chen, Rong, Sunnyvale, CA 94085 (US); Williams, Scott, Sunnyvale, CA 94085 (US)
(74) Representative: Peterreins, Frank

(57) **Abstract**

Methods for recess etching are provided herein that advantageously improve lateral to vertical etch ratio requirements, thereby enabling deeper recess etching while maintaining relatively shallow vertical etch depths. Such enhanced lateral etch methods advantageously provide benefits for numerous applications where lateral to vertical etch depth ratios are constrained or where recesses or cavities are desired to be formed. In some embodiments, a method of recess etching includes providing a substrate having a structure formed thereon; forming a recess in the substrate at least partially beneath the structure using a first etch process; forming a selective passivation layer on the substrate; and extending the recess in the substrate using a second etch process. The selective passivation layer is generally formed on regions of the substrate adjacent to the structure but generally not within the recess. The first and second etch processes may be the same or different.

## Description

### BACKGROUND

### Field

Embodiments of the present invention generally relate to fabrication of devices on semiconductor substrates, and, more specifically, to methods for recess etching during the fabrication of such devices.

### Description of the Related Art

Ultra-large-scale integrated (ULSI) circuits may include more than one million electronic devices (e.g., transistors) that are formed on a semiconductor substrate, such as a silicon (Si) wafer, and cooperate to perform various functions within the device. Typically, the transistors used in the ULSI circuits are complementary metal-oxide-semiconductor (CMOS) field effect transistors. A CMOS transistor typically has a source region, a drain region, and a channel region between the source and drain. A gate structure comprising a polysilicon gate electrode is formed above and is separated from the channel region by a gate dielectric to control conduction between the source and drain.

The performance of such devices can be improved, for example, by strain engineering. For example, the atomic lattice of a deposited material may be stressed to improve the electrical properties of the material itself, or of underlying or overlying material that is strained by the force applied by a stressed deposited material, which may increase the carrier mobility of semiconductors, such as silicon. Such increased mobility thereby increases the saturation current of doped silicon transistors to thereby improve their performance. In the CMOS example, localized lattice strain can be induced in the channel region of the transistor by the deposition of component materials of the transistor which have internal compressive or tensile stresses.

In some embodiments, this is accomplished by partially etching away the silicon substrate beneath the gate structure and depositing a silicon-germanium layer thereover to induce strain in the device. Typically, the silicon substrate beneath the gate structure is laterally etched to a point proximate the channel region of the substrate to enhance the Si-Ge strain effect. However, as the technology nodes continue to shrink, for example from 65 nm nodes to 45 nm and even 32 nm nodes, tighter constraints are placed upon the etch processes utilized to form these structures. For example, shallower junction depths limit the vertical distance that the silicon substrate may be etched. As such, the ratio of vertical to lateral etch distance decreases, thereby undesirably constraining conventional etch processes utilized to fabricate these structures, which may require greater vertical etch to lateral etch ratios. Moreover, microloading effects due to closer spacing of structures being formed on the substrate further exacerbates the problem by increasing the vertical etch to lateral etch requirement of the etch process.

Thus, there is a need for an improved etch process for recess etching.

### SUMMARY

Methods for recess etching are provided herein that advantageously improve lateral to vertical etch ratio requirements, thereby enabling deeper recess etching while maintaining relatively shallow vertical etch depths. Such enhanced lateral etch methods advantageously provide benefits for numerous applications where lateral to vertical etch depth ratios are constrained or where recesses or cavities are desired to be formed. In some embodiments, a method of recess etching includes providing a substrate having a structure formed thereon; forming a recess in the substrate at least partially beneath the structure using a first etch process; forming a selective passivation layer on the substrate; and extending the recess in the substrate using a second etch process. The selective passivation layer is generally formed on regions of the substrate adjacent to the structure but generally not within the recess. The first and second etch processes may be the same or different.

In some embodiments, a method of recess etching includes providing a substrate having a patterned mask layer formed thereon; etching a feature into the substrate through the patterned mask using a first etch process; forming a protective layer on sidewalls of the feature; removing a bottom portion of the protective layer to expose the substrate; and etching a cavity into the substrate using a second etch process.

### BRIEF DESCRIPTION OF THE DRAWINGS

So that the manner in which the features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figures 1A-E schematically depict stages of fabrication of a gate electrode in accordance with some embodiments of the present invention.

Figure 2 depicts a method for recess etching in accordance with some embodiments of the present invention and as illustrated in Figures 1A-E

Figures 3A-E schematically depict stages of fabrication of a gate electrode in accordance with some embodiments of the present invention.

Figure 4 depicts a method for recess etching in accordance with some embodiments of the present invention and as illustrated in Figures 3A-D.

Figure 5 depicts a schematic diagram of an exemplary plasma processing apparatus of the kind used in performing portions of the inventive method.

To facilitate understanding, identical reference numerals have been used, where possible, to designate identical elements that are common to the figures. The drawings are simplified for ease of understanding and are not drawn to scale.

### DETAILED DESCRIPTION

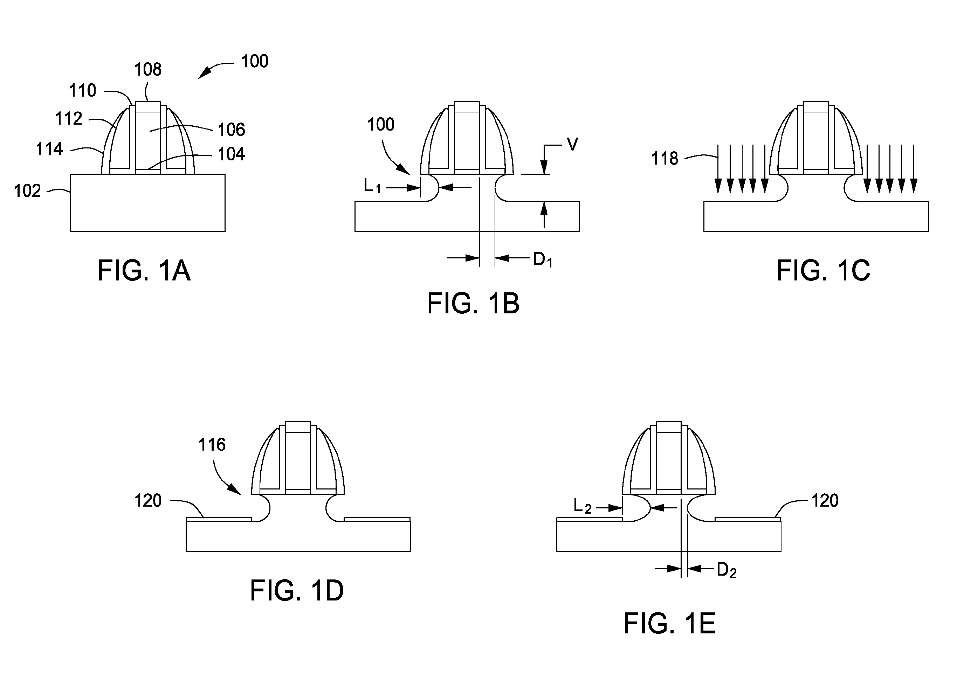

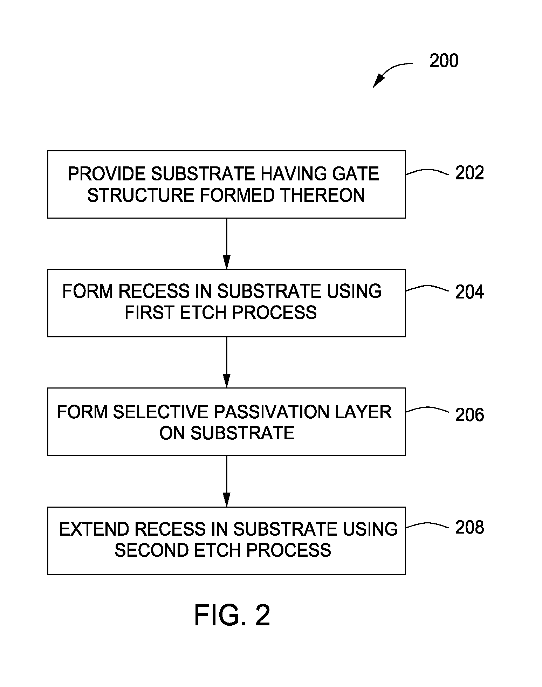

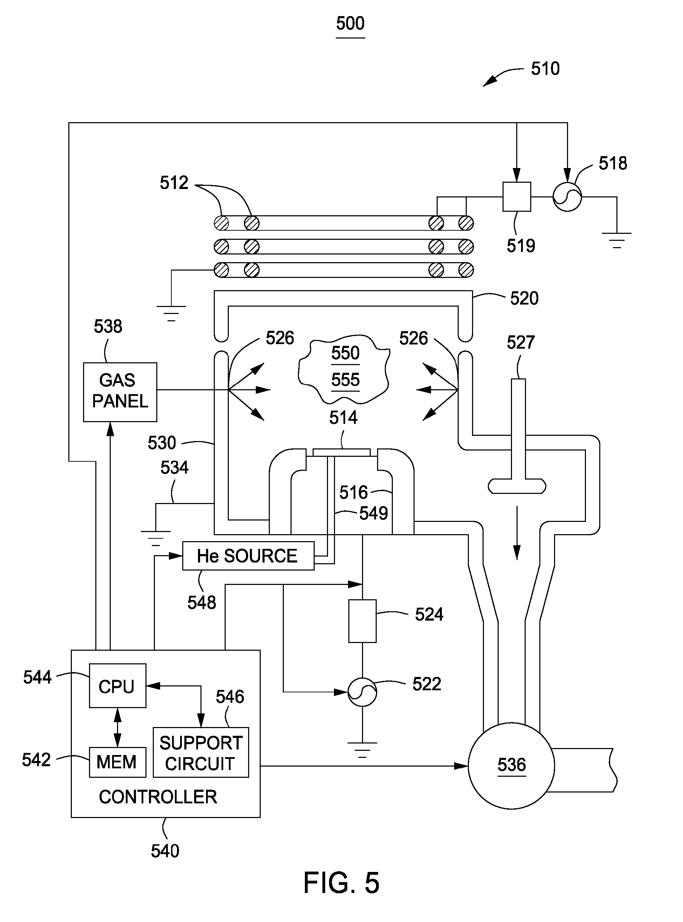

Figures 1A-E depict stages of fabrication of an illustrative gate structure in accordance with some embodiments of the present invention. Figure 2 depicts one illustrative method for recess etching in accordance with some embodiments of the present invention and is described below with reference to Figures 1A-E. Suitable reactors that may be adapted for use with the teachings disclosed herein include, for example, the Decoupled Plasma Source (DPS^{®}) ADVANTEDGE^{™} reactor, or the DPS^{®} I or DPS^{®} II etch reactor, all of which are available from Applied Materials, Inc. of Santa Clara, California. The DPS^{®} ADVANTEDGE^{™}, DPS^{®} I or DPS^{®} II reactors may also be used as processing modules of a CENTURA^{®} integrated semiconductor wafer processing system, also available from Applied Materials, Inc. An illustrative embodiment of a suitable etch reactor is described below with respect to Figure 5.

The method 200 begins at 202, where in one exemplary embodiment of the present invention, a substrate 102 having an illustrative gate structure 100 formed thereupon may be provided (as shown in Figure 1A). The substrate 102 may be a silicon substrate, although other types of substrates may be suitably utilized. The illustrative gate structure 100 may comprise a gate dielectric 104 having a gate electrode 106 formed thereover and a hard mask 108 formed atop the gate electrode 106. A liner 110 and spacer structure 112 are typically disposed on either side of the gate structure 100. A cap layer 114 may also be present on the gate structure 100.

The materials forming the illustrative gate structure 100 may be any materials suitable for use in a gate structure. For example, the gate dielectric 104 may be fabricated from hafnium dioxide (HfO₂), silicon dioxide (SiO₂), or the like. The gate electrode 106 may comprise polysilicon or other conductive materials, such as metals or metal-containing materials. The hard mask 108 may comprise a high temperature oxide (HTO), tetraethooxysilane (TEOS) oxide, silicon oxynitride (SiON), silicon nitride (SiN), or the like. The liner 110 may comprise a thermal oxide, HTO, or the like. The spacer structure 112 may comprise silicon nitride. The cap layer 114 may comprise silicon oxide. It is contemplated that other materials may suitably be used in accordance with the teachings provided herein.

Next, at 204, a first etch process is utilized to form a recess 116 in the substrate beneath the gate structure 100 (as shown in Figure 1 B). The first etch process is an isotropic etch process that has a vertical etch component, as indicated by etching the substrate 102 to a vertical depth, V, as well as laterally etching the substrate 102 beneath the gate structure 100 to a lateral depth, L₁. An alternative description of the recess 116 may include measuring the distance of an inner edge of the recess 116 perpendicular from an adjacent edge of the gate electrode 106, as shown in Figure 1B as distance D₁.

The first etch process may be any suitable isotropic etch process. In one illustrative example for etching a silicon substrate, a process gas comprising nitrogen trifluoride (NF₃) may be provided, optionally in combination with at least one of chlorine (Cl₂), oxygen (O₂), and an inert gas, such as argon (Ar). A plasma may be formed from the process gas utilizing between about 200 - 1000 Watts of a source power at a frequency of about 13.56 MHz. A low bias power, or optionally no bias power, is provided to facilitate etching in all directions (isotropically) on the substrate 102, thereby forming the recess 116.

In some embodiments, the first etch process may be run until a desired vertical etch depth, V, is reached. Alternatively, the first etch process may be run until the recess 166 obtains a desired lateral etch depth, L₁. The first etch process may be timed to run for a desired duration.

Next, at 206, a passivation layer 120 (in one example, an oxidation layer) may be selectively formed upon the substrate 102 (as shown in Figures 1C and 1D) in regions adjacent to the gate structure 100, but not beneath the gate structure 100 (i.e., not within the recess 116). The passivation layer 120 may be selectively formed on the substrate 102 by selectively exposing the substrate 102 to a plasma of a passivation gas (such as an oxygen containing gas in the oxidation layer example). In some embodiments, the passivation gas may comprise oxygen-based gases, such as oxygen (O₂) or helium-oxygen (He-O₂); carbon-based gases, such as difluoromethane (CH₂F₂) or other polymer forming gases; boron trichloride (BCl₃); or the like. Additional process gases such as one or more inert gases (such as argon) may also be utilized. To selectively form the passivation layer 120, an anisotropic plasma may be formed (as indicated by arrows 118 in Figure 1 C) by utilizing source power as described above in combination with a bias power. Alternatively, the plasma may be formed using solely the bias power. In some embodiments, the bias power may be about 100-700, or about 200, Watts of an about 13.56 MHz signal. The anisotropic plasma advantageously selectively forms the passivation layer 120 on exposed regions of the substrate 102, but not in sheltered regions of the substrate 120, such as within the recess 116. The plasma may be formed for a duration long enough to form the passivation layer 120 to a suitable thickness (such as a few nanometers, or between about 1-10 nm, or about 3 nm). In some embodiments, the plasma is formed for a few seconds, or about seven seconds, or just long enough to form a stable plasma.

Next, at 208, the recess 116 may be extended beneath the gate structure 100 to a desired lateral depth, L₂ using a second etch process (as shown in Figure 1 E). The final lateral depth, L₂, will typically depend upon the requirements for the particular structure being formed or for a particular application. Alternatively, the extended recess 116 may be described as having a perpendicular inner edge-to-gate electrode 106 distance of D₂ (as shown in Figure 1 E). In one non-limiting example, in a 45 nanometer technology node gate structure - having a width of, for example about 320 Angstroms or less according to the International Technology Roadmap for Semiconductors (ITRS) - the final distance D₂ may be at least about 150 Angstroms, depending upon final requirements.

The second etch process may be the same as the first etch process described above. Advantageously, the passivation layer 120 protects the substrate 102 from further undesirable vertical etching, thereby substantially maintaining the vertical depth, V, that the substrate 102 was etched during 204. Thus, the inner edge of the extended recess 116 is advantageously closer to a channel region of the substrate 102 disposed beneath the gate dielectric 104 and gate electrode 106, thereby enabling an enhancement of the silicon-germanium (Si-Ge) strain effect for PMOS (or silicon-carbide (Si-C) for NMOS) upon formation of a strain control layer (e.g., a Si-Ge layer or a Si-C layer) atop the substrate 102 and within the recess 116. In addition, the passivation layer formation advantageously forms a passivation layer atop the gate structure 100, which allows independent control of cap oxide open, hard mask (HM) and spacer loss, thereby advantageously widening the process window for control of the hard mask 108, spacer layer 112, and feature-dependency microloading.

In the example of a one-step selective passivation/lateral etch process, upon completion of 208, the method may end. Alternatively, one or more of 204 - 208 may be repeated as desired in a multiple-step process to achieve greater lateral recess depths and a desired feature profile. In some embodiments, 208 (the second recess step) may be controlled to provide a lower selectivity to the passivation layer to increase the lateral etch (increase the depth of the recess) as well as to remove the passivation layer. Alternatively or in combination, in some embodiments a passivation layer removal step may be added to control the thickness of the passivation layer during multiple-step processes.

Upon completion of the recess etch method, any remaining passivation layer may be removed, such as by a wet clean process or any suitable process for the type of passivation layer remaining and the other materials comprising the substrate and gate structure or other features being formed thereon. The substrate having the feature formed thereon may now continue to other processes to complete fabrication of the device, such as in the gate structure example, epitaxial growth of a strain control layer (e.g., a Si-Ge layer or a Si-C layer) atop the substrate and within the recess, and the like.

Although the foregoing discussion refers to fabrication of one exemplary type of gate structure, other types of gate structures comprising varying material combinations may also be formed using the inventive methods disclosed herein. Additionally, fabrication of other devices and structures used in integrated circuits that may utilize recess etching during fabrication sequences may also benefit from the invention. For example, in one non-limiting or example, the inventive recess etch method may be applied to straight flash stacks to gain selectivity between WSiₓ and Poly-Si layers.

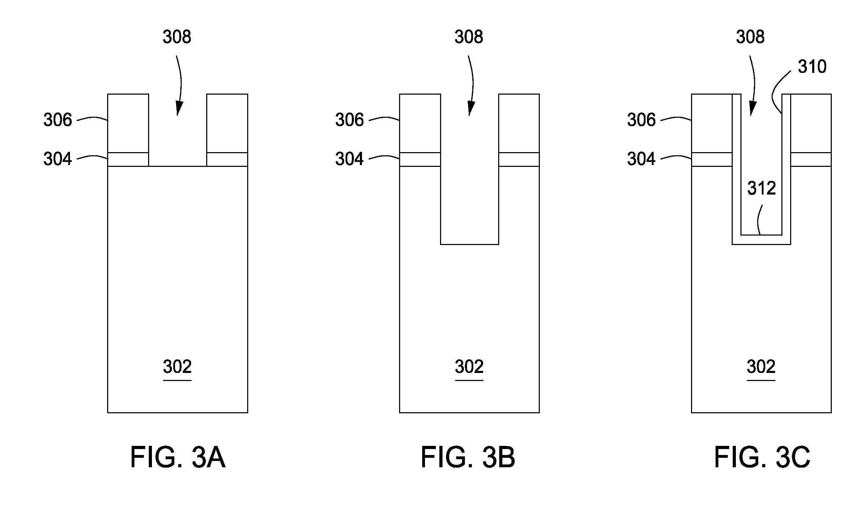

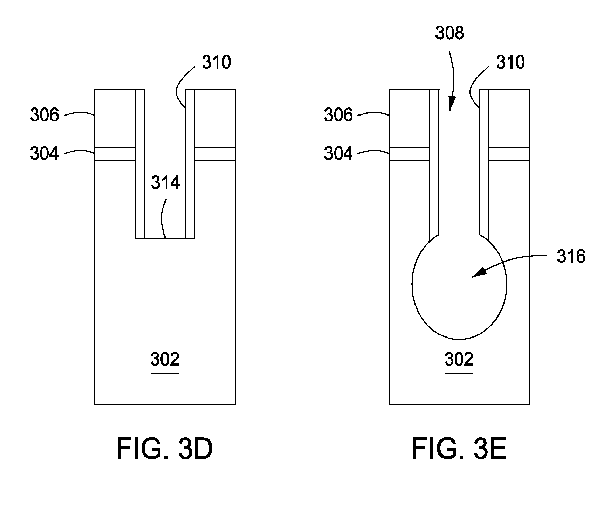

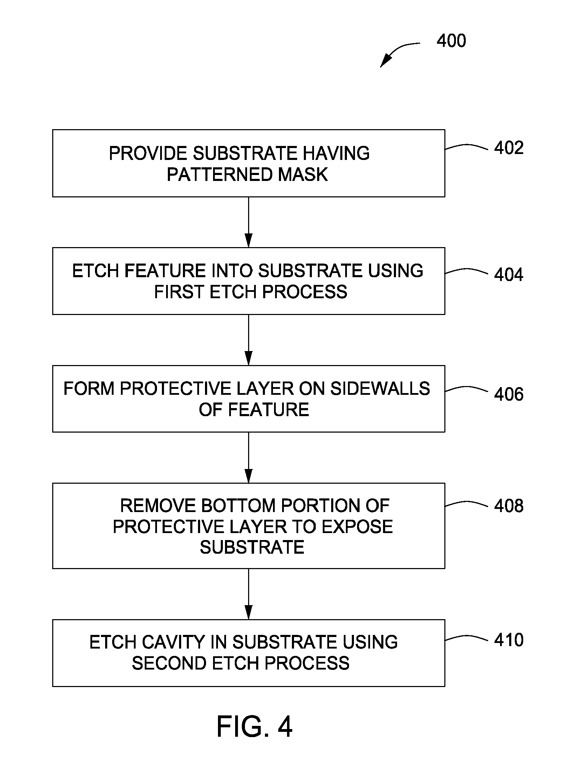

In some embodiments, and as depicted in Figures 3A-E and Figure 4, a spherical recessed channel array transistor (S-RCAT) may be advantageously fabricated. Figures 3A-E depict stages of fabrication of an illustrative S-RCAT structure in accordance with some embodiments of the present invention. Figure 4 depicts one illustrative method for recess etching in accordance with some embodiments of the present invention and is described below with reference to Figures 3A-E. Suitable reactors that may be adapted for use with the teachings disclosed herein include, for example, the Decoupled Plasma Source (DPS^{®}) ADVANTEDGE^{™} reactor, or the DPS^{®} I or DPS^{®} II etch reactor. An illustrative embodiment of a suitable etch reactor is described below with respect to Figure 5.

The method 400 begins at 402, where in one exemplary embodiment of the present invention, a substrate 302 may be provided having a patterned mask layer 306 formed thereupon (as shown in Figure 3A). The substrate 302 may be a silicon substrate, although other types of substrates may be suitably utilized. The patterned mask layer 306 generally has at least one feature 308 defined therein and may be any suitable mask layer for use in patterning the substrate 302 as described herein, such as a photosensitive resist layer (e.g., positive or negative photoresist) or a hardmask (e.g., silicon nitride (Si₃N₄), silicon oxide (SiO₂), or the like). In some embodiments one or more intervening layers 304 may be provided between the patterned mask layer 306 and the substrate 302. For example, in some embodiments, the intervening layer 304 may comprise a pad oxide, or silicon oxide (SiO₂) layer. Although described with respect to certain embodiments having certain layers as shown in Figures 3A-D, it is contemplated that other layers may also be present on the substrate 302 when fabricating S-RCAT structures, or other structures, in accordance with the teachings disclosed herein.

Next, at 404, a first etch process is utilized to etch the feature 308 into the substrate 302, as shown in Figure 3B. The first etch process may be any suitable etch process that primarily etches the feature 308 vertically into the substrate 302 to a desired depth. In one illustrative example for etching a silicon substrate, at least one halogen-containing process gas, such as nitrogen trifluoride (NF₃), sulfur hexafluoride (SF₆), hydrogen bromide (HBr), or the like, may be provided. For example, in some embodiments, up to about 100 sccm NF₃, up to about 50 sccm SF₆, and/or up to about 400 sccm HBr may be provided. In some embodiments, at least one of chlorine (Cl₂) oxygen (O₂), or nitrogen (N₂) may also be provided. For example, in some embodiments, up to about 400 sccm Cl₂ up to about 30 sccm O₂, and/or up to about 50 sccm N₂ may be provided.

A plasma may be formed from the process gas utilizing between about 200 - 1200 Watts of a source power at a suitable frequency (such as about 13.56 MHz). A bias power of between about 150 - 300 Watts at a suitable frequency (such as about 2 MHz) may also be provided. In some embodiments the pressure inside the process chamber may be maintained between about 4-70 mTorr. The first etch process may be run until a desired vertical etch depth is reached, for example by monitoring the etch process or by performing the etch process for a predetermined duration.

Next, at 406, a protective layer 310 may be formed within the feature 308 (as shown in Figure 3C). In some embodiments, the protective layer 310 may be formed in an ion-enhanced oxidation process, such as by exposing the substrate 102 to a plasma formed from an oxygen-containing gas, such as oxygen (O₂), and one or more inert gases, such as argon (Ar), to form an oxide layer within the feature 308 and on the substrate 302. The ion-enhanced oxidation process advantageously penetrates deep into the sidewalls of the feature 308 to form a protective layer 310 that can withstand subsequent processing.

In some embodiments, between about 100 - 500 sccm O₂ and between about 100 - 300 sccm Ar may be provided to the process chamber. The process chamber may be maintained at a pressure of between about 4 - 20 mTorr. A plasma may be formed from the process gas utilizing between about 500 - 1500 Watts of a source power at a suitable frequency (such as about 13.56 MHz). A bias power of between about 150 - 300 Watts at a suitable frequency (such as about 2 MHz) may also be provided. The plasma may be maintained until the spacer structure 310 reaches a desired thickness, for example by monitoring the etch process or by performing the etch process for a predetermined duration.

The protective layer 310 typically also forms along a bottom portion 312 of the feature 308 in addition to the sidewalls (as shown in Figure 4C). As such, at 408, the bottom portion 312 of the protective layer 310 may be removed, or opened, to expose a surface 314 of the substrate 302 (as shown in Figure 4D). The bottom portion 312 of the protective layer 310 may be opened by any suitable process for etching the materials that form the protective layer 310 in a manner that can remove the bottom portion 312 prior to removing all of the materials disposed on the sidewalls of the feature 308. For example, in some embodiments where the protective layer 310 comprises oxygen, a plasma may be formed from a fluorine-containing gas, such as carbon tetrafluoride (CF₄). An inert gas (such as Argon (Ar)) may also be provided. In some embodiments, between about 100 - 200 sccm CF₄ and between about 100 - 200 sccm of Ar may be provided.

The process chamber may be maintained at a pressure of between about 4 - 20 mTorr. A plasma may be formed from the process gas utilizing between about 200 - 1000 Watts of a source power at a suitable frequency (such as about 13.56 MHz). A bias power of between about 30 - 300 Watts at a suitable frequency (such as about 2 MHz) may also be provided. The plasma may be maintained until the bottom portion 312 of the protective layer 310 is completely or mostly removed, for example by monitoring the etch process or by performing the etch process for a predetermined duration. The ion-enhanced oxidation process utilized at 406 to form the protective layer 310 may advantageously provide a strong, deep oxidation layer on the sidewalls of the feature 308 that can withstand the etch process utilized to remove the bottom portion 312 of the protective layer 310.

Next, at 410, a recess, or cavity 316 may be formed in the substrate 302. The cavity 316 may be formed by a second etch process. The second etch process may be any suitable isotropic etch process that etches the cavity 316 into the substrate 302 to a desired size. In one illustrative example for etching a silicon substrate, at least one halogen-containing process gas, such as nitrogen trifluoride (NF₃), sulfur hexafluoride (SF₆), or the like, may be provided. For example, in some embodiments, up to about 50 sccm NF₃,and/or up to about 50 sccm SF₆ may be provided. In some embodiments, at least one of chlorine (Cl₂) oxygen (O₂), nitrogen (N₂), argon (Ar), or helium (He) may also be provided. For example, in some embodiments, up to about 200 sccm Cl₂ up to about 50 sccm O₂, up to about 50 sccm N₂, up to about 300 sccm Ar, and/or up to about 400 sccm He may be provided.

A plasma may be formed from the process gas utilizing between about 200 - 1500 Watts of a source power at a suitable frequency (such as about 13.56 MHz). A bias power of up to about 300 Watts at a suitable frequency (such as about 2 MHz) may also be provided. In some embodiments the pressure inside the process chamber may be maintained between about 4 - 50 mTorr. The second etch process may be run until a desired size of the cavity 316 is reached, for example by monitoring the etch process or by performing the etch process for a predetermined duration.

The formation of the protective layer 310 and the etching of the cavity 316 in the substrate 302 may be repeated until a cavity 316 of a desired size is formed, while advantageously not widening the feature 308. Upon completion of the recess etch method, any remaining oxidation layer (e.g., protective layer 310) may be removed, such as by a wet clean process or any suitable process for the type of layer remaining and the other materials comprising the substrate and other features being formed thereon. The substrate having the feature formed thereon may now continue to other processes to complete fabrication of the device, such as in the S-RCAT example, filling of the recess and fabricating a desired gate structure atop the substrate.

Thus, in accordance with embodiments of the invention as discussed above with respect to Figures 3A-E and Figure 4, a method for etching a substrate is provided that may include providing a substrate having a patterned mask layer formed thereon; etching a feature into the substrate through the patterned mask using a first etch process; forming a protective layer on sidewalls of the feature; removing a bottom portion of the protective layer to expose the substrate; and etching a cavity into the substrate using a second etch process.

In some embodiments of the above example, the patterned mask layer is at least one of a photoresist or a hard mask. In some embodiments, the first etch process may include providing at least one halogen-containing process gas; and forming a plasma from the process gas utilizing between about 200 - 1200 Watts of a source power. In some embodiments, forming the protective layer may include exposing the substrate to a plasma formed from an oxygen-containing gas and one or more inert gases to form an oxide layer within the feature.

In some embodiments, forming the protective layer may further include providing between about 100 - 500 sccm O₂ and between about 100 - 300 sccm Ar; and forming a plasma from the process gas utilizing between about 500 - 1500 Watts of a source power. In some embodiments, removing the bottom portion of the protective layer may include providing between about 100 - 200 sccm CF₄ and between about 100 - 200 sccm of Ar; forming a plasma from the process gas utilizing between about 200 - 1000 Watts of a source power; and maintaining the plasma until the bottom portion of the protective layer is substantially removed without removing the protective layer from the sidewalls of the feature.

In some embodiments, etching the cavity into the substrate may include forming an isotropic plasma that etches the cavity into the substrate to a desired size. In some embodiments, etching the cavity into the substrate may further include providing at least one halogen-containing process gas; and forming the isotropic plasma from the process gas utilizing between about 200 - 1500 Watts of a source power. In some embodiments, the process gas of the second etch process may further include at least one of chlorine (Cl₂) oxygen (O₂), nitrogen (N₂), argon (Ar), or helium (He). In some embodiments, up to about 50 sccm NF₃, and/or up to about 50 sccm SF₆ may be provided. In some embodiments, up to about 200 sccm Cl₂ up to about 50 sccm O₂, up to about 50 sccm N₂, up to about 300 sccm Ar, and/or up to about 400 sccm He may be provided.

Figure 5 depicts a schematic diagram of an exemplary etch reactor 500 that may be used to practice portions of the invention. The reactor 500 comprises a process chamber 510 having a substrate support pedestal 516 within a conductive body (wall) 530, and a controller 540.

The chamber 510 is supplied with a substantially flat dielectric ceiling 520. Other embodiments of the chamber 510 may have other types of ceilings, such as a dome-shaped ceiling. An antenna comprising at least one inductive coil element 512 is disposed above the ceiling 520 (two co-axial elements 512 are shown). The inductive coil element 512 is coupled, through a first matching network 519, to a plasma power source 518. The plasma source 518 typically is capable of producing up to 3000 W at a tunable frequency in a range from 50 kHz to 13.56 MHz.

The support pedestal (cathode) 516 is coupled, through a second matching network 524, to a biasing power source 522. The biasing source 522 generally is capable of producing up to 500 W at a frequency of approximately 13.56 MHz. The biasing power may be either continuous or pulsed power. In other embodiments, the biasing power source 522 may be a DC or pulsed DC source.

A controller 540 comprises a central processing unit (CPU) 544, a memory 542, and support circuits 546 for the CPU 544 and facilitates control of the components of the chamber 510 and, as such, of the etch process, as discussed above in further detail.

In operation, a semiconductor substrate 514 is placed on the pedestal 516 and process gases are supplied from a gas panel 538 through entry ports 526 and form a gaseous mixture 550. The gaseous mixture 550 is ignited into a plasma 555 in the chamber 510 by applying power from the plasma source 518 and biasing power source 522 to the inductive coil element 512 and the cathode 516, respectively. The pressure within the interior of the chamber 510 is controlled using a throttle valve 527 and a vacuum pump 536. Typically, the chamber wall 530 is coupled to an electrical ground 534. The temperature of the wall 530 is controlled using liquid-containing conduits (not shown) that run through the wall 530.

The temperature of the substrate 514 is controlled by stabilizing a temperature of the support pedestal 516. In one embodiment, the helium gas from a gas source 548 is provided via a gas conduit 549 to channels (not shown) formed in the pedestal surface under the substrate 514. The helium gas may be used to facilitate heat transfer between the pedestal 516 and the substrate 514. During processing, the pedestal 516 may be heated by a resistive heater (not shown) within the pedestal to a steady state temperature and then the helium gas facilitates uniform heating of the substrate 514. Using such thermal control, the substrate 514 is maintained at a temperature of between about 20 and 80 degrees Celsius.

Those skilled in the art will understand that other etch chambers may be used to practice the invention, including chambers with remote plasma sources, electron cyclotron resonance (ECR) plasma chambers, and the like.

To facilitate control of the process chamber 510 as described above, the controller 540 may be one of any form of general-purpose computer processor that can be used in an industrial setting for controlling various chambers and sub-processors. The memory 542, or computer-readable medium, of the CPU 544 may be one or more of readily available memory such as random access memory (RAM), read only memory (ROM), floppy disk, hard disk, or any other form of digital storage, local or remote. The support circuits 546 are coupled to the CPU 544 for supporting the processor in a conventional manner. These circuits include cache, power supplies, clock circuits, input/output circuitry and subsystems, and the like. The inventive method is generally stored in the memory 542 as a software routine, which, when executed, may control the etch reactor 500 to perform the inventive method. The software routine may also be stored and/or executed by a second CPU (not shown) that is remotely located from the hardware being controlled by the CPU 544.

The invention may be practiced using other semiconductor wafer processing systems wherein the processing parameters may be adjusted to achieve acceptable characteristics by those skilled in the art by utilizing the teachings disclosed herein without departing from the spirit of the invention.

Thus, a method for recess etching has been provided that advantageously improves lateral to vertical etch ratio capabilities, thereby enabling deeper lateral recess etching while maintaining relatively shallow vertical etch depths. Such enhanced lateral etch methods advantageously provide benefits for numerous applications where vertical to lateral etch depth ratios are constrained (e.g., applications requiring greater lateral etching and/or less vertical etching).

While the foregoing is directed to embodiments of the present invention, other and further embodiments of the invention may be devised without departing from the basic scope thereof, and the scope thereof are determined by the following claims.

## Claims

1. A method for etching a substrate, comprising:
providing a substrate having a structure formed thereon;
forming a recess in the substrate at least partially beneath the structure using a first etch process;
forming a selective passivation layer on the substrate; and
extending the recess in the substrate using a second etch process.

2. The method of claim 1, wherein the selective passivation layer is formed on regions of the substrate adjacent to the structure but substantially not within the recess.

3. The method of claim 1, wherein the first etch process comprises:
providing a process gas comprising nitrogen trifluoride (NF₃) and, optionally, at least one of chlorine (Cl₂), oxygen (O₂), or an inert gas.

4. The method of claim 1, wherein the selective passivation layer comprises an oxide layer formed by exposing the substrate to a plasma of an oxygen containing gas comprising at least one of oxygen (O₂) or helium-oxygen (He-O₂).

5. The method of claim 1, wherein forming the selective passivation layer comprises:
exposing the substrate to a plasma of a passivation gas comprising at least one of a carbon-based gas, a polymer forming gas, or boron trichloride (BCl₃).

6. The method of claim 5, wherein the passivation gas comprises difluoromethane (CH₂F₂).

7. The method of claim 1, wherein forming the selective passivation layer comprises:
exposing the substrate to a plasma; and
applying a bias power to a substrate support pedestal supporting the substrate.

8. The method of claim 1, wherein the gate structure has a width of about 320 Angstroms or less, and wherein extending the recess in the substrate comprises:
etching the recess to a depth of at least about 150 Angstroms.

9. The method of claim 1, further comprising:
repeatedly forming the selective passivation layer on the substrate and extending the recess in the substrate using the second etch process until a desired recess depth is reached.

10. The method of claim 1, further comprising:
forming a strain control layer atop the substrate and within the recess.

11. The method of claim 10, wherein the strain control layer comprises a silicon and germanium layer or a silicon and carbon layer.

12. A method for etching a substrate, comprising:
providing a substrate having a patterned mask layer formed thereon;
etching a feature into the substrate through the patterned mask using a first etch process;
forming a protective layer on sidewalls of the feature;
removing a bottom portion of the protective layer to expose the substrate; and
etching a cavity into the substrate using a second etch process.

13. The method of claim 12, wherein the first etch process comprises:
providing at least one halogen-containing process gas; and
forming a plasma from the process gas utilizing between about 200 - 1200 Watts of a source power.

14. The method of claim 12, wherein forming the protective layer comprises:
exposing the substrate to a plasma formed from an oxygen-containing gas and one or more inert gases to form an oxide layer within the feature.

15. The method of claim 14, further comprising:
providing between about 100 - 500 sccm O₂ and between about 100-300 sccm Ar; and
forming a plasma from the process gas utilizing between about 500-1500 Watts of a source power.
